Europäisches Patentamt

European Patent Office

Office européen des brevets

(11) Publication number: **0 470 584 A2**

# EUROPEAN PATENT APPLICATION

(21) Application number: **91113230.6**

(22) Date of filing: **06.08.91**

(51) Int. Cl.⁵: **B32B 31/20**, B32B 31/12, B29D 9/00, B32B 15/08, B32B 17/04, B29C 43/30, B29C 43/48, B29C 43/52, //B29L31:34

(30) Priority: **06.08.90 JP 209028/90**
**15.02.91 JP 44178/91**
**24.04.91 JP 122486/91**

(43) Date of publication of application:
**12.02.92 Bulletin 92/07**

(84) Designated Contracting States:
**BE DE FR GB**

(71) Applicant: **KANEGAFUCHI KAGAKU KOGYO KABUSHIKI KAISHA**
**2-4 Nakanoshima 3-chome**
**Kita-ku Osaka-shi(JP)**

(72) Inventor: **Maki, Haruhiko**
**16 Takaharacho Tanakahigashi**
**Sakyo-ku, Kyoto(JP)**
Inventor: **Kikukawa, Osamu**
**3-3 Kayanoura Otsu**
**Shiga-ken(JP)**
Inventor: **Shimomura, Masayoshi**
**137-1 Minamihama Shigacho**
**Shiga-gun, Shiga-ken(JP)**

(74) Representative: **Kinzebach, Werner, Dr. et al**
**Patentanwälte Reitstötter, Kinzebach und Partner Sternwartstrasse 4 Postfach 86 06 49**
**W-8000 München 86(DE)**

(54) Continuous production of metal clad laminates.

㊼ A process for producing metal clad laminates comprising the steps, all in continuous manner, of:
    (a) joining a plurality of substrate sheets impregnated with a liquid resin capable of curing without generating volatile by-products to form a wet laminate;
    (b) applying a metal foil onto at least one side of the wet laminate;
    (c) preheating the wet laminate immediately before or after step (b) before the liquid resin is immobilized;
    (d) compressing and heating the wet laminate by a double belt press in its pressing zone to cure the laminate into a rigid state;
    (e) subjecting the lamiate to curing after releasing it from compression to complete the curing reaction and to relax internal stress therein; and
    (f) cutting the cured laminate to a predetermined length.

EP 0 470 584 A2

## Background of the Invention

This invention relates to a process for continuously producing metal clad laminates which are used in making printed circuit wiring boards by the subtraction method.

These metal clad laminates have been conventionally produced by the batchwise, dry process in which a fibrous substrate impregnated with a resin solution is dried to obtain a "prepreg". It is cut to a predetermined length, and several cut sheets are stacked together with a metal foil placed on one or both sides of the stack and subjected to heat and pressure in a hot press.

Attempts have been made to develop a continuous process for producing the metal clad laminates to increase productivity and to decrease cost. U.S. Patent Nos. 4,372,800; 4,451,317; 4,571,279; 4,662,973 and 4,994,133, all assigned to the assignee of the present application, describe a continuous process in which a plurality of substrate sheets are impregnated with a thermosetting liquid resin capable of curing without generating volatile by-products, e.g. unsaturated polyester resins. The impregnated sheets are then joined into a wet laminate with a conductive metal foil applied on one or both sides, and the wet laminate carrying the metal foil is cured in an oven without applying molding pressure. This process is hereinafter designated as the "pressure-free, wet process".

Recent developments in electric and electronic instruments have imposed on the metal clad laminates more and more stringent performance requirements, particularly those under heated conditions. To comply with these requirements, it is effective to increase the proportion of substrates in the laminate by decreasing the resin content. However, since no molding pressure is applied during the curing step in the pressure-free, wet process, a decrease in the resin content tends to cause a decrease in the interlayer adhesion strength making it impractical. Furthermore, the pressure-free, wet process allows the metal foil to dislodge relative to the substrate layers at least at the initial stage of curing. Irregularities or waves may often be produced in the finished product on the clad surfaces due to the difference in the thermal expansion coefficient between different materials or vibration.

In order to overcome this problem, a continuous wet process has been developed in which the wet laminate is cured under pressure while being sandwiched between oppositely facing turns of a double belts press. See, for example, Japanese Patent Publication No. 58031/85, and EP 0347936. This process is hereinafter referred to as the "wet compression process".

It has been discovered that the wet compression process requires various operational parameters and conditions which are substantially different from those employed in the pressure-free wet process. For example, it is necessary in the pressure-free, wet process to feed an excess of resin to each substrate sheet so as to prevent air bubbles from entering between substrate and metal foil layers when they are joined together; whereas, in case of the wet compression process, the amount of resin should not be in excess because excessive resin liquid would be expressed out from the wet laminate by the double belt press and deposited on the press itself and other surrounding parts.

It has also been discovered that the known wet compression processes are not entirely satisfactory in respect to the product performance. For example, the laminates produced by the prior art process often tend to cause distortions and/or blisters when heated to an elevated temperature during processing or use of a printed circuit wiring board.

It is, therefore, a major object of the present invention to provide an improved process for producing metal clad laminates which eliminates or ameliorates the above disadvantages.

## Summary of the Invention

The present invention provides a process for producing metal clad laminates comprising the steps of:

(a) joining a plurality of substrate sheets impregnated with a liquid resin capable of curing without generating volatile by-products to about 100 % to 108 % saturation to form a wet laminate;

(b) applying a metal foil onto at least one side of the wet laminate;

(c) preheating the wet laminate immediately before or after step (b) before the liquid resin becomes immobilized;

(d) compressing and heating the wet laminate by a double belt press in its pressing zone to cure the laminate into a rigid state;

(e) subjecting the laminate to curing after releasing it from compression to complete the curing reaction and to relax internal stress; and

(f) cutting the cured laminate to a predetermined length;

all of steps (a) through (f) being carried out while the plurality of substrate sheets and their joined laminate are continuously moving.

## Brief Description of the Drawings

Fig. 1 is a schematic side view of an embodiment of the process of the present invention, and

Fig. 2 is a similar view to Fig. 1 of another embodiment thereof.

Detailed Description of the Preferred Embodiments

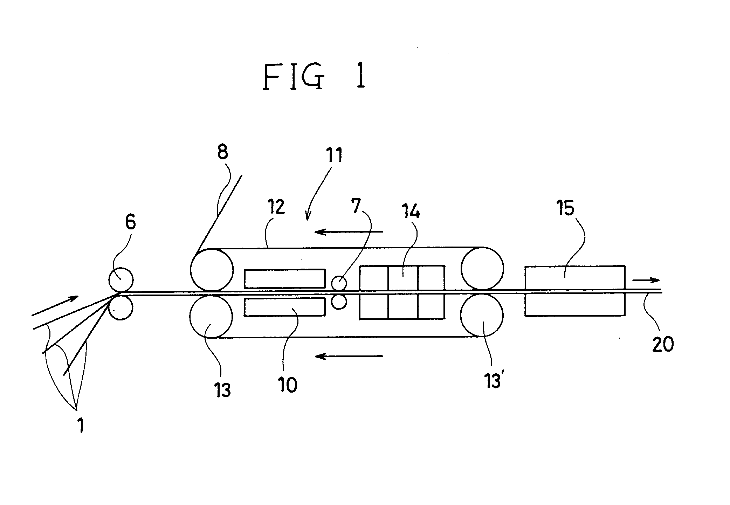

Referring now to the drawings, an embodiment of the present invention and an apparatus used therein are shown schematically in Fig. 1. Since the process and apparatus may be essentially identical to those of prior art such as disclosed in previously cited United States patent literatures except that the apparatus shown additionally comprises a preheating zone 10 within each endless belt loop 12 of the double belt press 11 as well as a curing oven 15, several steps up to the impregnating step have been omitted in Fig. 1.

A plurality of resin-impregnated substrate sheets 1 are joined together by a pair of rolls 6 to a wet laminate which, in turn, is cured in a double belt press generally shown at 11 after applying a metal foil 8 onto at lease one side.

The double belt press 11 comprises, as is well-known, a pair of endless belt loops 12 between which the wet laminate is compressed. Each endless belt loop 12 is threaded around a pair of rollers 13, 13' and both belt loops 12 are driven sychronously with the wet laminate sandwiched therebetween. Within the endless belt loop 12 on either side are provided a preheating zone 10, a compression roll 7 and a pressing box 14. The preheating zone 10 is a chamber in which hot air or other heating medium is circulating. Preferably, the roller 13 supporting the belt loop 12 at the upstream end may also be heated by circulating hot air, steam or other heating medium therein for saving the length or stroke of the preheating zone 10 within the belt loop 12. The compression roller 6 cooperates with the corresponding roller 6 on the opposite side to compact the wet laminate in expanded areas if produced by preheating. The pressure box 14 is preferably subdivided by one or more partition walls into a plurality of chambers within which a pressurized fluid such as air or hydraulic liquid is confined. The temperature of the pressurized fluid in each chamber is independently adjustable. Alternatively, a plurality of single chamber-pressure boxes may be placed side-by-side to allow independent control of their pressure and/or temperature. Instead of using a hydraulic pressure box 14 as shown, a plurality of oppositely facing roller pairs may be used for compressing the wet laminate between the pair of endless loops 12.

After passing through the double belt press 11, the laminate is subjected to curing in the absence of molding pressure in a curing oven 15 and the finished laminate 20 is cut to a predetermined length by a cutter (not shown).

Although the apparatus shown in Fig. 1 is for the production of one-sided metal clad laminates, it will be easily understood that the apparatus may be easily adapted to the production of two-sided metal clad laminates by applying a pair of metal foils 8 to the laminate symmetrically.

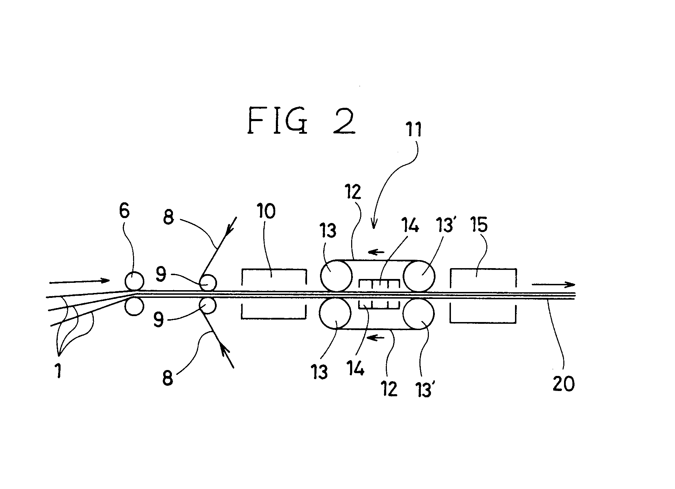

Fig. 2 shows an alternative embodiment which differs from the Fig. 1 embodiment in that the preheating zone 10 is positioned outside the double belt press 11 at the upstream end and a pair of cladding foils 8, 8 are applied by a pair of laminating rolls 9, 9 positioned upstream from the preheating zone 10.

According to the present invention, each of the plurality of substrate sheets is impregnated with a liquid resin which cures into a rigid state without generating any volatile by-product. Examples of such resins include unsaturated polyester resins, epoxy acrylate resins, polyester acrylate resins, epoxy resins and the like. Examples of substrates include cellulosic substrates such as cotton linter paper and kraft paper, glass-based substrates such as glass cloth and glass paper, and other substrates such as mixed-fiber paper, woven or nonwoven fabrics and the like.

The amount of liquid resin to be fed to the substrate should not be large excess but is adjusted to about 100 % to 108 % saturation. The term "saturation" as used herein refers to an amount of liquid resin sufficient to fill the total volume of voids or interstices present in the substrate before impregnation. This adjustment may be performed, for example, by metering the liquid resin, or by feeding an excessive amount of liquid resin to individual substrate sheets and then removing the excess of liquid resin therefrom using a scraping slit or squeezing rollers as disclosed in previously cited U.S. patent Nos. 4,372,800; 4,451,317; 4,571,279 and 4,994,133.

The impregnation step may be continuous with the remaining steps of the process of the present invention by continuously conveying various substrate sheets in parallel and impregnating them with the resin individually. Alternatively, the impregnation step may be carried out in a separate line from the other steps. Since substrates having a degree of impregnation of 100 % to 108 % saturation are not too tacky, they may be rolled and unrolled without blocking between turns. A mold release paper may be interposed between turns if necessary. The separation of the impregnation step from the remainder of the process of this invention has several advantages over in-line impregnation.

It can prevent the overall production line from becoming too long and eliminate a problem associated with the in-line impregnation system, namely that every occurrence of tear or rupture in one of the plurality of substrate sheets would cause the temporary stopping of the entire production line.

For similar reasons, cladding foil 8 such as copper foil may preferably be coated with an adhesive in a separate line, rolled and stored in a rolled form until use.

According to the present invention, the wet laminate is heated at least in three separate stages. The preheating zone 10 is intended to prevent the generation of blisters, interlayer delamination, bubbles and other defects in the wet laminate caused by sudden heating. Therefore, the wet laminate should not be allowed to cure in this preheating zone until the resin becomes immobilized. To this end, the axial length of this preheating zone preferably ranges between 0.25 and 2 times, more preferably between 0.3 to 1.2 times, the length of the press box 14. The temperature at which the wet laminate is heated in this preheating zone 10 generally lies between 80 °C and 110 °C. Then, the preheated wet laminate is heated in the press zone 14 within the double belt press 11. In the press zone 14, the laminate is allowed to cure into a rigid state under a pressure of not greater than 20 $kg/cm^2$, preferably from 1 to 10 $kg/cm^2$. The temperature at which the laminate is heated in the press zone 14 may vary depending upon the nature of the particular resin used and lies between 110 °C and 160 °C for unsaturated polyester resins.

The laminate is finally subjected to curing before cutting to a predetermined length. This step is carried out in an oven shown at 15 in Figs. 1 and 2. The oven may be of conventional tunnel type in which hot air or other suitable heat medium is circulating. No pressure is applied to the laminate 20 in this curing step so that any internal stress generated in the laminate in the preceding step may be relaxed. The temperature at which the laminate is heated in this step may be the same or slightly higher than the temperature employed in the press zone 14.

Thus, the wet laminate 20 is allowed to cure progressively in various steps under different conditions such that the curing reaction takes place up to 10 %, preferably up to 6 %, in the preheating zone 10, from 40 % to 90 %, preferably from 60 % to 80 %, in the press zone 14, and to completion in the curing zone 15, respectively.

It will be understood that the embodiments of the present invention which have been shown and described are merely illustrative but not limitative. Numerous modifications may be made by those skilled in the art without departing from the sprit and scope of the invention. For example, a cover sheet such as a polyester film may be applied on the opposite side of the wet laminate from the metal clad side and peeled off after the curing step when one-sided metal clad laminates are intended. Furthermore, after cutting to a predetermined length, the laminates may be subjected to a batchwise annealing step.

## Claims

1. A process for producing metal clad laminates comprising the steps of:

    (a) joining a plurality of substrate sheets impregnated with a liquid resin capable of curing without generating volatile by-products to about 100 % to 108 % saturation to form a wet laminate;

    (b) applying a metal foil onto at least one side of the wet laminate;

    (c) preheating the wet laminate immediately before or after step (b) before the liquid resin becomes immobilized;

    (d) compressing and heating the wet laminate by a double belt press in its pressing zone to cure the laminate into a rigid state;

    (e) subjecting the laminate to curing after releasing it from compression to complete the curing reaction and to relax internal stress, and

    (f) cutting the cured laminate into a predetermined length;

    all of steps (a) through (f) being carried out while the plurality of substrates sheets and their joined laminate are continuously moving.

2. The process as claimed in Claim 1, wherein the curing reaction of said liquid resin is allowed to proceed, up to 10 %, and from 40 % to 90 % in said steps (c) and step (d), respectively.

3. The process as claimed in Claim 2, wherein said curing reaction is allowed to proceed, up to 6 % and from 60 % to 80 % in said step (c) and step (d), respectively.

4. The process as claimed in Claim 1 further including the step of impregnating said plurality of substrate sheets individually with said liquid resin while conveying them in parallel, said impregnating step being continuous with said steps (a) through (f).

5. The process as claimed in Claim 4, wherein said plurality of substrate sheets are impregnated with an amount of said liquid resin in excess of about 100 % to 108 % saturation and then the excessive amount of said liquid resin is removed by scraping or squeezing.

6. The process as claimed in Claim 1, wherein said plarality of substrate sheets are impregnated with said liquid resin in a separate line from said steps (a) through (f), and supplied to said step (a).

7. The process as claimed in Claim 6, wherein said plurality of substrate sheets are impregnated with an amount said liquid resin in excess of about 100 % to 108 % and then the excessive amount of said resin is removed by scraping or squeezing.

8. The process as claimed in Claim 1, wherein said liquid resin is an unsaturated polyester resin, epoxy acrylate resin, polyester acrylate resin or a mixture thereof.

9. The process as claimed in Claim 1, wherein said liquid resin is an epoxy resin.

10. The process as claimed in Claim 1, wherein said substrate is a cellulosic substrate.

11. The process as claimed in Claim 1, wherein said substrate is a glass fiber-based substrate.

12. The process as claimed in Claim 1, wherein said metal foil is copper.

13. The process as claimed in Claim 1, wherein said metal foil is coated with an adhesive in a separate line from the steps (a) through (f) and supplied at said step (b).

14. The process as claimed in Claim 1 further including, subsequent to said step (f), the step of subjecting said cut length of the laminate to annealing.

FIG 2